# FASCICULE DE BREVET EUROPEEN

(11) **EP 2 678 183 B1**
(45) Date de publication et mention de la délivrance du brevet: **06.04.2016**
(21) Numéro de dépôt: 11808900.2
(22) Date de dépôt: 16.12.2011
(51) Int. Cl.: B60K 37/06, G01L 1/20, G06F 3/045, H01H 13/702, H03K 17/96

(54) **DISPOSITIF DE COMMANDE POUR VÉHICULE AUTOMOBILE**
STEUERVORRICHTUNG FÜR EIN KRAFTFAHRZEUG
MOTOR VEHICLE CONTROL DEVICE

(30) Priorité: 21.12.2010 FR 1004995
(43) Date de publication de la demande: 01.01.2014
(73) Titulaire: Valeo Systemes Thermiques, 78320 Le Mesnil Saint Denis (FR)
(72) Inventeur: HUYNH, Tan Duc, F-93330 Neuilly Sur Marne (FR); VANHELLE, Stéphane, F-74970 Marignier (FR)
(74) Mandataire: Pothmann, Karsten
(86) Numéro de dépôt international: PCT/FR2011/000660
(87) Numéro de publication internationale: WO 2012/085360

(56) Documents cités:
- WO-A1-2005/073634
- DE-A1-102008 014 443
- US-A- 5 952 630

## Description

La présente invention concerne un dispositif de commande pour véhicule automobile comportant au moins un capteur de force présentant au moins une surface sensible à une pression d'appui.

Un dispositif comprenant toutes les caractéristiques du préambule de la revendication est connu du DE 10 2008 014493A1.

Pour augmenter le confort ergonomique dans le domaine automobile, l'utilisation d'une technologie à capteur tactile pour les commandes des divers organes électriques est considérée comme un développement intéressant. En effet, les capteurs de force utilisant des résistances sensibles à la pression (également connu sous le nom de capteur « FSR » pour « Force Sensing Resistor »), ont fait des progrès importants. Les surfaces sensibles des capteurs de force permettent de détecter un appui simple du doigt du conducteur et, en fonction de la position de l'appui détecté et/ou du déplacement ultérieur de cet appui sur la surface, de déclencher un type particulier d'action ou de commande d'organe du véhicule.

Les capteurs de force sont protégés par une façade sur laquelle l'utilisateur exerce un appui pour activer le capteur de force. La façade comprend pour cela des zones déformables associées aux surfaces sensibles du(ou des) capteurs de force. Cependant, une certaine rigidité est requise pour des notions de qualité perçue par utilisateur et de stabilité. De plus, dans l'art antérieur connu la force d'actionnement peut ne pas être homogène lorsque l'on appuie au centre ou en étant un peu décalé par rapport à la zone déformable. En outre, des déformations trop importantes peuvent être nécessaires pour réussir à activer le capteur de force.

Un des buts de l'invention est de proposer un dispositif de commande permettant de pallier aux inconvénients de l'état de la technique.

À cet effet, l'invention a pour objet un dispositif de commande pour véhicule automobile comprenant :
- au moins un capteur de force présentant au moins une surface sensible à une pression d'appui,
- une façade comprenant au moins une zone déformable associée à ladite surface sensible dudit capteur de force,
caractérisé en ce qu'il comporte en outre un moyen de précontrainte agencé sur ladite surface sensible pour exercer une pression d'appui de précontrainte sur ladite surface sensible afin de décaler la zone de fonctionnement du capteur de force, ledit moyen de précontrainte comporte au moins un élément de précontrainte en matériau souple interposé entre ladite surface sensible du capteur de force et la façade.

Ainsi, lorsqu'un appui est exercé sur la surface sensible, une résistance équivalente peut immédiatement être déduite de la pression exercée, par soustraction de la pression d'appui de précontrainte. Le décalage de la zone de fonctionnement permet de réduire la course de déformation nécessaire pour atteindre la zone utile de fonctionnement du capteur de force dans laquelle une variation de pression engendre directement une variation de signal correspondant en sortie du capteur de force.

Ledit dispositif de commande peut comporter en outre une ou plusieurs des caractéristiques suivantes, prise seule ou en combinaison :
- ledit élément de précontrainte est une pièce distincte de la façade, réalisé en silicone ou en thermoplastique élastomère,
- ledit élément de précontrainte exerce une pression d'appui de précontrainte localisée en au moins une zone d'activation de ladite surface sensible du capteur de force,
- la façade comporte un matériau transparent ou translucide au moins au niveau de la zone déformable et la surface sensible à une pression d'appui entoure au moins partiellement une zone centrale du capteur de force laissant passer la lumière, la zone centrale étant en vis-à-vis de la zone déformable de la façade,
- les éléments de précontrainte sont au moins partiellement opaques,
- l'élément de précontrainte exerce une pression d'appui de précontrainte au moins localisée en deux zones d'activation, respectivement de part et d'autre d'une zone centrale laissant passer la lumière,
- ledit dispositif de commande comporte :
   - une pluralité de surfaces sensibles à une pression d'appui entourant au moins partiellement une zone centrale respective laissant passer la lumière en vis-à-vis d'une zone déformable associée de la façade,
   - au moins un élément de précontrainte entre une première et une deuxième surfaces sensibles du capteur de force, en appui d'une part avec ladite première surface sensible et d'autre part, avec ladite deuxième surface sensible,
- entre deux surfaces sensibles, lesdits éléments de précontrainte présentent une forme générale de pontet,
- la pression d'appui de précontrainte exercée par le moyen de précontrainte sur ladite surface sensible est au moins égale ou supérieure à 0, 5 Newton.

D'autres caractéristiques et avantages de l'invention ressortiront de la description suivante, donnée à titre d'exemple, sans caractère limitatif, en regard des dessins annexés sur lesquels :
- la figure 1 est une vue schématique en coupe transversale d'un dispositif, de commande pour véhicule automobile selon un premier mode de réalisation d'invention, avec une vue de dessus du capteur de force,
- la figure 2 est un graphique représentant un exemple d'une courbe de résistance en kohms d'un capteur de force en fonction de la force d'appui en Newton, et
- la figure 3 est un graphique représentant un dispositif de commande pour véhicule automobile selon un deuxième mode de réalisation, non conformant à l'invention.

Sur ces figures et dans la suite de la description, les éléments identiques sont identifiés par les mêmes numéros de référence. Sur les figures et dans le texte, le « haut » du dispositif de commande est désigné par le côté portant la façade.

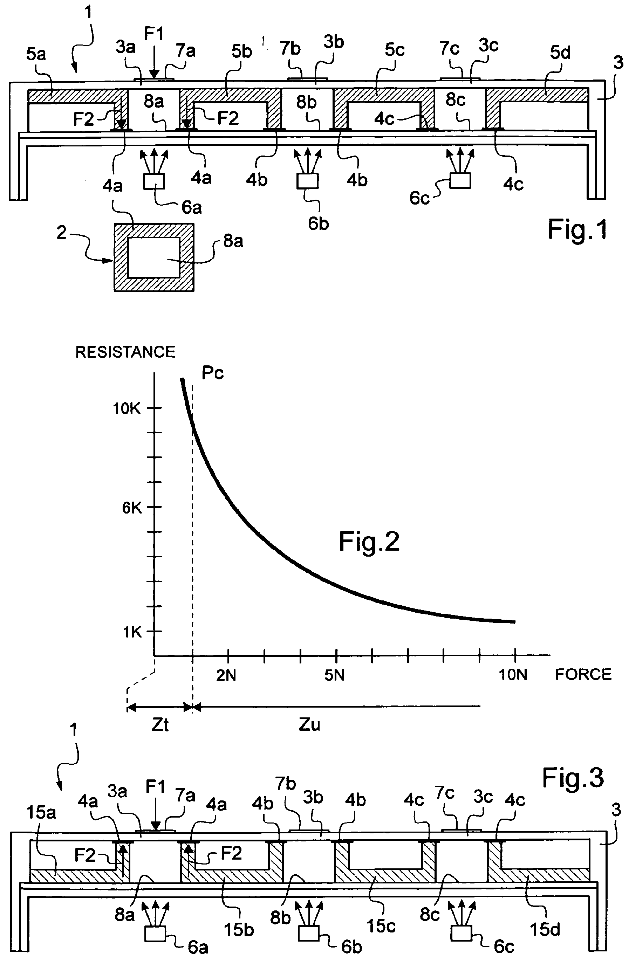

La figure 1 illustre un premier mode de réalisation d'un dispositif de commande 1 destiné à la commande de fonctions d'au moins un organe de véhicule automobile. Le dispositif de commande 1 est notamment propre à être logé dans un panneau de bord ou dans une façade rapportée de véhicule automobile. Plus précisément, un tel dispositif de commande 1 peut trouver une application pour les commandes se trouvant au niveau de la console centrale et entre les deux sièges avant d'un véhicule automobile pour par exemple commander des fonctions de climatisation, d'un système audio, d'un système de téléphonie ou encore d'un système de navigation. Egalement, le dispositif de commande 1 peut être logé dans le dôme du véhicule au niveau de l'emplacement habituel du rétroviseur intérieur, pour par exemple commander des lumières intérieures, un verrouillage central, un toit ouvrant, les feux de détresse ou les lumières d'ambiance. Ce dispositif de commande 1 peut également servir pour les commandes de lève-vitres, des commandes de positionnement des rétroviseurs extérieurs ou encore des commandes de déplacement de sièges motorisés.

Conformément à l'exemple illustratif de la figure 1, le dispositif de commande 1 comporte trois capteurs de force 2 et une façade 3 comprenant trois zones déformables 3a, 3b, 3c respectivement associées à une surface sensible à une pression d'appui 4a, 4b, 4c des capteurs de force 2. Dans l'exemple de la figure 1, chaque capteur de force 2 comporte une unique surface sensible à une pression d'appui 4a, 4b, 4c. De façon alternative, un unique capteur de force peut porter plusieurs surfaces sensibles à une pression d'appui (non représenté).

Les capteurs de force 2 utilisent des résistances sensibles à la pression (également connus sous le nom de capteur FSR pour « Force Sensing Resistor ») permettant de détecter un appui simple d'un utilisateur et, en fonction de l'intensité de l'appui exercé sur la surface sensible 4a, 4b, 4c, de déclencher un type particulier de commande. En exerçant une pression sur la couche FSR, sa résistance ohmique diminue permettant ainsi, par application d'une tension électrique adaptée, de mesurer la pression appliquée et / ou la localisation de l'endroit où la pression est exercée. Ces capteurs de force 2 présentent l'avantage d'être minces et souples. Ils permettent que le dispositif de commande 1 soit compact et que les capteurs de force 2 puisse être activés avec de faibles courses d'actionnement.

La technologie employée pour les surfaces sensibles du capteur de force est par exemple celle décrite dans le document US 4, 810, 992 ou FR 2683649 ou US 5, 008, 497. Les surfaces sensibles comportent une couche isolante muni sur un premier côté d'une première couche conductrice et d'une deuxième couche conductrice sur le côté opposé. Selon un premier exemple, au moins une des deux couches conductrices est une couche de semi-conducteur sensible à une variation de pression. Une variation de contact entre les couches entraîne une modification de la résistance à travers la couche semi-conductrice. Selon un deuxième exemple, au lieu d'appliquer une couche conductrice contre la couche FSR, on peut utiliser une pellicule résistive portant un réseau conducteur déposé sur la pellicule sous forme de deux peignes d'électrodes en disposition interdigitale. Cette pellicule est alors scellée à la couche FSR de manière que les peignes d'électrodes affleurent la couche semi-conductrice FSR. Si aucune force n'est appliquée à une telle structure, la résistance entre les bornes des peignes d'électrodes est très élevée. Par contre, lorsque le FSR est soumis à une force, la couche FSR shunte les électrodes et la résistance diminue selon l'intensité de la force. Selon un troisième exemple, le capteur de force comporte une couche FSR prise en sandwich entre une couche résistive et une couche conductrice.

Selon un autre exemple de technologie, les surfaces sensibles du capteur de force sont celles décrites par exemple dans les documents EP 1 429 356 ou EP 1 429 355. Le capteur de force comporte deux feuilles souples de support espacées l'une de l'autre par des entretoises dans lesquelles des trous définissant les surfaces sensibles, sont ménagés. Dans les surfaces sensibles, les feuilles souples de support portent sur des faces mutuellement en regard des éléments sensibles à une variation de pression, telle qu'une encre résistive imprimée comme du carbone, permettant de réaliser un contact électrique lors de la compression du capteur. Les entretoises, par exemple élastiques, comportent une colle ou un adhésif à double face.

Les zones déformables 3a, 3b, 3c de la façade 3 sont agencées au-dessus d'une surface sensible 4a, 4b, 4c respective du capteur de force 2 de manière qu'une déformation de la zone déformable 3a, 3b, 3c par un utilisateur soit transmise au capteur de force associé 2, pour activer la surface sensible 4a, 4b, 4c respective et commander la fonction d'un organe du véhicule.

La façade 3 est par exemple en polycarbonate et présente une épaisseur de l'ordre de 0,5 mm à 0,8 mm, ce qui lui confère une certaine rigidité. La façade 3 peut également comporter un empilement de plusieurs couches de matériau. Bien que la figure 1 représente une façade 3 sensiblement plane, celle-ci peut alternativement présenter une forme légèrement bombée (non représentée). Les zones déformables 3a, 3b, 3c sont par exemple formées par un amincissement localisé de la façade 3.

En outre, le dispositif de commande 1 comporte au moins un moyen de précontrainte agencé sur la surface sensible du capteur de force 2 pour exercer continuellement (c'est-à-dire d'une part, au repos lorsqu'aucune force n'est appliquée et en fonctionnement d'autre part, lorsqu'un appui est exercé sur la façade) une pression d'appui de précontrainte Pc sur la surface sensible 4a, 4b, 4c. On décale ainsi la zone de fonctionnement du capteur de force 2. La pression d'appui de précontrainte Pc exercée par le moyen de précontrainte sur la surface sensible est par exemple au moins égale ou supérieure à0, 5 Newton.

Selon un premier mode de réalisation, le moyen de précontrainte comporte des éléments de précontrainte 5a, 5b, 5c, 5d (quatre dans l'exemple de la figure 1), en matériau souple, interposés entre deux surfaces sensibles 4a, 4b, 4c du capteur de force 2 et la façade 3.

Les éléments de précontrainte 5a, 5b, 5c, 5d sont par exemple en silicone ou en thermoplastique élastomère. Ils sont plus souples que la façade 3, voire élastiques, de manière à être déformés au cours d'un appui. Ce sont par exemple des éléments distincts de la façade 3, réalisés en une ou plusieurs pièces.

La figure 2 illustre un exemple d'une courbe de résistance en kohms d'une surface sensible d'un capteur de force 2 en fonction de la force d'appui en Newton. On distingue sur cette courbe, une première zone transitoire Zt, entre 0 et 1 Newton, dans laquelle un appui exercé sur la surface sensible 4a, 4b, 4c ne permet pas de percevoir une variation de résistance représentative de l'appui. En revanche, on voit que pour une pression d'appui supérieure à 1 Newton, la zone de fonctionnement du capteur de force 2 permet d'associer à une pression d'appui d'utilisateur, une résistance d'un ordre de grandeur compatible avec une chaîne d'acquisition de données classique. Par conséquent, pour une pression d'appui de précontrainte Pc de l'ordre de 1N, on décale la zone de fonctionnement (Zt+Zu) du capteur de force 2 au-delà de la zone transitoire Zt, dans une nouvelle zone utile Zu. Ainsi, lorsqu'un appui est exercé sur la surface sensible 4a, 4b, 4c, une résistance équivalente peut immédiatement être déduite de la pression exercée, par soustraction de la pression d'appui de précontrainte Pc.

Avec des éléments de précontrainte agencés entre la façade 3 et le capteur de force 2, le décalage de la zone de fonctionnement du capteur de force 2 présente au moins deux conséquences :
- on réduit la course de déformation entre la façade 3 et le capteur de force 2 respectif car il n'a plus d'espace vide entre la façade 3 et le capteur de force 2, et
- on réduit la course de déformation nécessaire pour atteindre la zone utile Zu de fonctionnement du capteur de force 2 dans laquelle une variation de pression engendre directement une variation de signal correspondant en sortie du capteur de force 2.

La pression d'appui de précontrainte Pc exercée peut être localisée en une ou plusieurs zones d'activation de la surface sensible du capteur de force 2, concentrant la force d'appui en ces zones. Pour cela, les éléments de précontrainte 5a, 5b, 5c, 5d présentent par exemple une forme de pontet ou « en L » avec une face sensiblement parallèle à la façade 3 et au moins un pilier qui dirige et concentre les efforts exercés sur la face de l'élément de précontrainte 5a, 5b, 5c, 5d en une zone d'activation localisée de la surface sensible 4a, 4b, 4c.

Conformément à l'exemple illustré sur la figure 1, un premier élément de précontrainte 5b en forme de pontet est agencé pour exercer une pression d'appui de précontrainte Pc sur une première surface sensible 4a et sur une deuxième surface sensible 4b. De même, un deuxième élément de précontrainte 5c en forme de pontet est agencé pour exercer une pression d'appui de précontrainte la deuxième surface sensible 4b et sur une troisième surface sensible 4c. En outre, un troisième élément de précontrainte 5a à une première extrémité de la façade 3, en forme de L, exerce une pression d'appui de précontrainte Pc sur la première surface sensible 4a et un quatrième élément de précontrainte 5d à une deuxième extrémité de la façade 3, en forme de L, exerce une pression d'appui de précontrainte Pc sur la quatrième surface sensible 4d.

Ainsi agencés, les éléments de précontrainte 5a, 5b, 5c, 5d forment des butées de séparation entre chaque zone déformable 3a, 3b, 3c. Lorsque l'utilisateur appuie sur une zone déformable 3a, 3b, 3c, les éléments de précontrainte 5a, 5b, 5c, 5d dirigent la force d'appui F1 vers une ou l'autre des surfaces sensibles 4a, 4b, 4c de sorte qu'une seule surface sensible soit activée à la fois.

Egalement, les éléments de précontrainte 5a, 5b, 5c, 5d font offices de concentrateurs de force puisque la force d'appui F1 exercée sur la façade 3 est concentrée en des zones d'activation précises de la surface sensible 4a, 4b, 4c (voir flèche F2 d'appui). On augmente la pression d'appui F2 exercée au niveau des zones d'activation de la surface sensible du capteur de force 2.

Selon un mode particulier de réalisation, le dispositif de commande 1 comporte des moyens de rétroéclairage permettant de mieux visualiser, par exemple en conduite de nuit, les zones déformables 3a, 3b, 3c de la façade 3 pouvant être actionnées par l'utilisateur.

Pour cela, le dispositif de commande 1 comporte des sources lumineuses 6a, 6b, 6c (trois dans l'exemple illustratif de la figure 1), agencées à l'arrière des zones déformables respectives 3a, 3b, 3b.

En outre, la façade 3 comporte des symboles ou signes ou encore des chiffres, des lettres ou des pictogrammes 7a, 7b, 7c en rapport avec l'organe ou la fonction à commander au niveau des zones déformables 3a, 3b, 3c. La façade 3 peut également comporter un film de décoration et/ou de protection, par exemple en plastique, et les symboles peuvent être réalisés par sérigraphie sur la face inférieure du film (non représenté). Ces symboles peuvent être visibles en permanence ou en variante uniquement par rétro-éclairage. Dans ce cas, les symboles sont réalisés en un matériau laissant passer la lumière au moins partiellement et en absence d'une source lumineuse, la façade 3 apparaît uniforme sans indication ou écriture au niveau de la ou des zones déformables 3a, 3b, 3c. La planche de bord apparaît donc uniforme, par exemple avec une surface visible lisse. En outre, le matériau de la façade 3 est transparent ou translucide au moins au niveau de la ou des zones déformables 3a, 3b, 3c présentant les symboles.

Les surfaces sensibles 4a, 4b, 4c interposées entre les sources lumineuses 6a, 6b, 6c et les symboles 7a, 7b, 7c, entourent au moins partiellement une zone centrale respective 8a, 8b, 8c des capteurs de force 2, laissant passer la lumière. Ces zones centrales 8a, 8b, 8c sont agencées en vis-à-vis des zones déformables 3a, 3b, 3c associées de la façade 3. La zone centrale 8a, 8b, 8c, telle que circulaire ou parallélépipédique (figure 1), est par exemple constituée d'un trou traversant. Selon un autre exemple, la zone centrale 8a, 8b, 8c présente une encre conductrice transparente. La surface sensible 4a, 4b, 4c entourant la zone centrale 8a, 8b, 8c peut comporter une encre opaque ou également conductrice transparente.

Les éléments de précontrainte 5a, 5b, 5c, 5d exercent une pression d'appui de précontrainte au moins localisée en deux zones d'activation de la surface sensible du capteur de force 2, respectivement de part et d'autre des zone centrale 8a, 8b, 8c laissant passer la lumière. Les zones centrales 8a, 8b, 8c n'étant pas cachées par les éléments de précontrainte 5a, 5b, 5c, 5d, les symboles 7a, 7b, 7c des zones déformables 3a, 3b, 3b de la façade 3 peuvent être rétro-éclairés. Selon un autre exemple non représenté, les éléments de précontrainte sont en matériau translucide ou transparent, tel qu'en polycarbonate translucide, dans la colonne entre les zones centrales 8a, 8b, 8c et la façade 3. En outre, les éléments de précontrainte 5a, 5b, 5c, 5d peuvent présenter d'autres formes que celles en « L » ou en pontet. Ils sont par exemple conformés pour entourer, par exemple cercler, au moins partiellement la zone centrale 8a, 8b, 8c.

Par ailleurs, les éléments de précontrainte 5a, 5b, 5c, 5d peuvent être au moins partiellement opaques. Par exemple, les parois à l'aplomb des zones déformables 3a, 3b, 3c, présentent un coloris noir, formant des séparations de lumière entre chaque zone déformable 3a, 3b, 3c rétroéclairée. On évite ainsi la pollution lumineuse d'une zone déformable par une zone déformable adjacente rétroéclairée.

Le deuxième mode de réalisation non conformant à l'invention illustre en figure 3 se distingue principalement du premier mode de réalisation en ce que le capteur de force 2 est interposé entre les éléments de précontrainte 15a, 15b, 15c, 15d (quatre dans l'exemple de la figure 3) et la façade 3. Les moyen de précontrainte 15a, 15b, 15c, 15d en matériau souple sont en appui contre les surfaces sensibles des capteurs de force 2 et exercent une pression d'appui de précontrainte Pc par en dessous (voir flèches F2).

Avec des éléments de contrainte agencés à l'arrière du capteur de force 2, on décale comme précédemment la zone de fonctionnement du capteur de force 2 pour réduire la course de déformation entre la façade 3 et le capteur de force 2 et la course de déformation nécessaire pour atteindre la zone utile Zu de fonctionnement du capteur de force 2.

On comprend donc qu'un tel dispositif de commande 1 permet de générer une variation de commande représentative d'une pression d'appui de façon quasiment instantanée dès le contact du doigt de l'utilisateur sur la façade 3 et avec une grande précision.

## Revendications

1. Dispositif de commande pour véhicule automobile comprenant :
- au moins un capteur de force (2) présentant au moins une surface sensible à une pression d'appui (4a, 4b, 4c),
- une façade (3) comprenant au moins une zone déformable (3a, 3b, 3c) associée à ladite surface sensible (4a, 4b, 4c) dudit capteur de force (2),
le dispositif comportant un moyen de précontrainte agencé sur ladite surface sensible (4a, 4b, 4c) pour exercer une pression d'appui de précontrainte (Pc) sur ladite surface sensible (4a, 4b, 4c) afin de décaler la zone de fonctionnement du capteur de force (2), **caractérisé en ce que** ledit moyen de précontrainte comporte au moins un élément de précontrainte (5a, 5b, 5c, 5d) en matériau souple interposé entre ladite surface sensible (4a, 4b, 4c) du capteur de force (2) et la façade (3).

2. Dispositif de commande selon la revendication 1, **caractérisé en ce que** ledit élément de précontrainte (5a, 5b, 5c, 5d) est une pièce distincte de la façade (3), réalisé en silicone ou en thermoplastique élastomère. 2

3. Dispositif de commande selon l'une des revendications 1 à 2, **caractérisé en ce que** ledit élément de précontrainte (5a, 5b, 5c, 5d) exerce une pression d'appui de précontrainte (Pc) localisée en au moins une zone d'activation de ladite surface sensible (4a, 4b, 4c) du capteur de force (2).

4. Dispositif de commande selon l'une des revendications 1 à 3, **caractérisé en ce que** la façade (3) comporte un matériau transparent ou translucide au moins au niveau d'une zone déformable (3a, 3b, 3c) et **en ce que** la surface sensible à une pression d'appui (4a, 4b, 4c) entoure au moins partiellement une zone centrale (8a, 8b, 8c) du capteur de force (2) laissant passer la lumière, la zone centrale (8a, 8b, 8c) étant en vis-à-vis d'une zone déformable (3a, 3b, 3c) de la façade (3).

5. Dispositif de commande selon la revendication 4, prise ensemble avec l'une des revendications 1 à 4, **caractérisé en ce que** les éléments de précontrainte (5a, 5b, 5c, 5d) sont au moins partiellement opaques.

6. Dispositif de commande selon l'une des revendications 4 ou 5, prise ensemble avec la revendication 3, **caractérisé en ce que** l'élément de précontrainte (5a, 5b, 5c, 5d) exerce une pression d'appui de précontrainte au moins localisée en deux zones d'activation, respectivement de part et d'autre d'une zone centrale (8a, 8b, 8c) laissant passer la lumière.

7. Dispositif de commande selon l'une des revendications 4 à 6, **caractérisé en ce qu'**il comporte :
- une pluralité de surfaces sensibles à une pression d'appui (4a, 4b, 4c) entourant au moins partiellement une zone centrale (8a, 8b, 8c) respective laissant passer la lumière en vis-à-vis d'une zone déformable (3a, 3b, 3c) associée de la façade (3),
- au moins un élément de précontrainte (5b, 5c) entre une première et une deuxième surfaces sensibles (4a, 4b, 4c) du capteur de force (2), en appui d'une part avec ladite première surface sensible et d'autre part, avec ladite deuxième surface sensible.

8. Dispositif de commande selon l'une des revendications 3 ou 7, **caractérisé en ce qu'**entre deux surfaces sensibles (4a, 4b, 4c), lesdits éléments de précontrainte (5b, 5c) présentent une forme générale de pontet.

9. Dispositif de commande selon l'une des revendications précédentes, **caractérisé en ce que** la pression d'appui de précontrainte (Pc) exercée par le moyen de précontrainte sur ladite surface sensible (4a, 4b, 4c) est au moins égale ou supérieure à 0, 5 Newton.

## Patentansprüche

1. Steuervorrichtung für ein Kraftfahrzeug, die enthält:
- mindestens einen Kraftsensor (2), der mindestens eine für einen Auflagedruck empfindliche Fläche (4a, 4b, 4c) aufweist,
- eine Fassade (3), die mindestens eine verformbare Zone (3a, 3b, 3c) enthält, die der empfindlichen Fläche (4a, 4b, 4c) des Kraftsensors (2) zugeordnet ist,
wobei die Vorrichtung eine Vorspannungseinrichtung aufweist, die auf der empfindlichen Fläche (4a, 4b, 4c) angeordnet ist, um einen Vorspannungs-Auflagedruck (Pc) auf die empfindliche Fläche (4a, 4b, 4c) auszuüben, um die Betriebszone des Kraftsensors (2) zu verschieben, **dadurch gekennzeichnet, dass** die Vorspannungseinrichtung mindestens ein Vorspannungselement (5a, 5b, 5c, 5d) aus weichem Material aufweist, das zwischen die empfindliche Fläche (4a, 4b, 4c) des Kraftsensors (2) und die Fassade (3) eingefügt ist.

2. Steuervorrichtung nach Anspruch 1, **dadurch gekennzeichnet, dass** das Vorspannungselement (5a, 5b, 5c, 5d) ein von der Fassade (3) getrenntes Bauteil ist, hergestellt aus Silikon oder thermoplastischem Elastomer.

3. Steuervorrichtung nach einem der Ansprüche 1 bis 2, **dadurch gekennzeichnet, dass** das Vorspannungselement (5a, 5b, 5c, 5d) in mindestens einer Aktivierungszone der empfindlichen Fläche (4a, 4b, 4c) des Kraftsensors (2) einen lokalisierten Vorspannungs-Auflagedruck (Pc) ausübt.

4. Steuervorrichtung nach einem der Ansprüche 1 bis 3, **dadurch gekennzeichnet, dass** die Fassade (3) mindestens im Bereich einer verformbaren Zone (3a, 3b, 3c) ein durchsichtiges oder durchscheinendes Material aufweist, und dass die für einen Auflagedruck empfindliche Fläche (4a, 4b, 4c) zumindest teilweise eine das Licht durchlassende zentrale Zone (8a, 8b, 8c) des Kraftsensors (2) umgibt, wobei die zentrale Zone (8a, 8b, 8c) sich gegenüber einer verformbaren Zone (3a, 3b, 3c) der Fassade (3) befindet.

5. Steuervorrichtung nach Anspruch 4 zusammen mit einem der Ansprüche 1 bis 4, **dadurch gekennzeichnet, dass** die Vorspannungselemente (5a, 5b, 5c, 5d) zumindest teilweise undurchsichtig sind.

6. Steuervorrichtung nach einem der Ansprüche 4 oder 5 zusammen mit Anspruch 3, **dadurch gekennzeichnet, dass** das Vorspannungselement (5a, 5b, 5c, 5d) einen mindestens in zwei Aktivierungszonen lokalisierten Vorspannungs-Auflagedruck zu beiden Seiten einer das Licht durchlassenden zentralen Zone (8a, 8b, 8c) ausübt.

7. Steuervorrichtung nach einem der Ansprüche 4 bis 6, **dadurch gekennzeichnet, dass** sie aufweist:
- eine Vielzahl von für einen Auflagedruck empfindlichen Flächen (4a, 4b, 4c), die mindestens teilweise eine das Licht durchlassende zentrale Zone (8a, 8b, 8c) gegenüber einer zugeordneten verformbaren Zone (3a, 3b, 3c) der Fassade (3) umgeben,
- mindestens ein Vorspannungselement (5b, 5c) zwischen einer ersten und einer zweiten empfindlichen Fläche (4a, 4b, 4c) des Kraftsensors (2), in Auflage einerseits mit der ersten empfindlichen Fläche und andererseits mit der zweiten empfindlichen Fläche.

8. Steuervorrichtung nach einem der Ansprüche 3 oder 7, **dadurch gekennzeichnet, dass** die Vorspannungselemente (5b, 5c) zwischen zwei empfindlichen Flächen (4a, 4b, 4c) eine allgemeine Form einer Brücke aufweisen.

9. Steuervorrichtung nach einem der vorhergehenden Ansprüche, **dadurch gekennzeichnet, dass** der von der Vorspannungseinrichtung auf die empfindliche Fläche (4a, 4b, 4c) ausgeübte Vorspannungs-Auflagedruck (Pc) mindestens gleich oder höher als 0,5 Newton ist.

## Claims

1. Motor vehicle control device including:
- at least one force sensor (2) having at least one surface sensitive to a pressing pressure (4a, 4b, 4c),
- a frontage (3) comprising at least one deformable area (3a, 3b, 3c) linked with said sensitive surface (4a, 4b, 4c) of said force sensor (2),
the device comprising a pre-stressing means arranged on said sensitive surface (4a, 4b, 4c) to exert a pre-stressing pressing pressure (Ps) on said sensitive surface (4a, 4b, 4c) in order to shift the operating area of the force sensor (2), **characterized in that** said pre-stressing means comprises at least one pre-stressing element (5a, 5b, 5c, 5d) made from flexible material, which is inserted between said sensitive surface (4a, 4b, 4c) of the force sensor (2) and the frontage (3).

2. Control device according to Claim 1, **characterized in that** said pre-stressing element (5a, 5b, 5c, 5d) is a piece separate from the frontage (3), said element being made from silicone or thermoplastic elastomer.

3. Control device according to either of Claims 1 and 2, **characterized in that** said pre-stressing element (5a, 5b, 5c, 5d) exerts a pre-stressing pressing pressure (Ps) located at at least one activation area of said sensitive surface (4a, 4b, 4c) of the force sensor (2).

4. Control device according to one of Claims 1 to 3, **characterized in that** the frontage (3) comprises a transparent or translucent material at least at a deformable area (3a, 3b, 3c), and the surface sensitive to a pressing pressure (4a, 4b, 4c) surrounds at least partially a central area (8a, 8b, 8c) of the force sensor (2) letting light through, the central area (8a, 8b, 8c) being opposite a deformable area (3a, 3b, 3c) of the frontage (3).

5. Control device according to Claim 4, taken in conjunction with one of Claims 1 to 4, **characterized in that** the pre-stressing elements (5a, 5b, 5c, 5d, 15a, 15b, 15c, 15d) are at least partially opaque.

6. Control device according to either of Claims 4 and 5, taken in conjunction with Claim 3, **characterized in that** the pre-stressing element (5a, 5b, 5c, 5d) exerts a pre-stressing pressing pressure at least located at two activation areas, on either side, respectively, of a central area (8a, 8b, 8c) letting light through.

7. Control device according to one of Claims 4 to 6, **characterized in that** it comprises:
- a plurality of surfaces sensitive to a pressing pressure (4a, 4b, 4c) surrounding at least partially a respective central area (8a, 8b, 8c) letting light through opposite a linked deformable area (3a, 3b, 3c) of the frontage (3),
- at least one pre-stressing element (5b, 5c) between a first and a second sensitive surface (4a, 4b, 4c) of the force sensor (2), pressing against said first sensitive surface and against said second sensitive surface.

8. Control device according to either of Claims 3 and 7, **characterized in that**, between two sensitive surfaces (4a, 4b, 4c), said pre-stressing elements (5b, 5c) have a bridge piece general shape.

9. Control device according to one of the preceding claims, **characterized in that** the pre-stressing pressing pressure (Ps) exerted by the pre-stressing means on said sensitive surface (4a, 4b, 4c) is at least equal to or greater than 0.5 Newtons.
